Europäisches Patentamt

European Patent Office

Office européen des brevets

(11) Veröffentlichungsnummer : **0 032 550**
**B1**

(12) **EUROPÄISCHE PATENTSCHRIFT**

(45) Veröffentlichungstag der Patentschrift :
13.03.85

(21) Anmeldenummer : 80107626.6

(22) Anmeldetag : 04.12.80

(51) Int. Cl.⁴ : **H 01 L 29/36, H 01 L 21/265,**
**H 01 L 27/08, H 01 L 21/225**

(54) Verfahren zur Herstellung einer bipolaren, vertikalen PNP-Transistorstruktur.

(30) Priorität : 18.01.80 US 113168

(43) Veröffentlichungstag der Anmeldung :
29.07.81 Patentblatt 81/30

(45) Bekanntmachung des Hinweises auf die Patenterteilung : 13.03.85 Patentblatt 85/11

(84) Benannte Vertragsstaaten :
DE FR GB IT

(56) Entgegenhaltungen :
US-A- 3 730 786
IBM TECHNICAL DISCLOSURE BULLETIN, Band 22, Nr. 5, Oktober 1979, New York V.Y. DOO "Nine-Mask Complementary Bipolar Process" Seiten 1874 bis 1878
IBM TECHNICAL DISCLOSURE BULLETIN, Band 17, Nr. 1, Juni 1974 New York J.J. CHANG et al. "Complementary Bipolar Device Structure" Seiten 21 bis 22
JOURNAL OF APPLIED PHYSICS, Band 48, Nr. 5 Mai 1977 New York K. TSUKAMOTO et al. "Arsenic Implantation Into Polycrystalline Silicon and Diffusion to Silicon Substrate" Seiten 1815 bis 1821
IEEE JOURNAL OF SOLID-STATE CIRCUITS, Band SC-11, Nr. 4 August 1976 New York J. GRAUL et al. "High-Performance Transistors with Arsenic-Implanted Polysil Emitters" Seiten 491 bis 495
IEEE JOURNAL OF SOLID-STATE CIRCUITS, Band SC-15, Nr. 4, August 1980 New York I.E. MAGDO "Vertical p-n-p- for Complementary Bipolar Technology" Seiten 459 bis 461
JAPANESE JOURNAL OF APPLIED PHYSICS, Band 15, 1976 Supplement Tokyo Y. AKASAKA et al. "Application of Diffusion from Implanted Polycrystalline Silicon to Bipolar Transistors Seiten 49 bis 54

(73) Patentinhaber : International Business Machines Corporation
Old Orchard Road
Armonk, N.Y. 10504 (US)

(72) Erfinder : Magdo, Ingrid Emese
Frances Drive
Hopewell Junction New York 12533 (US)
Erfinder : Rupprecht, Hans Stephen
3505 Kamhi Drive
Yorktown Heights New York 10598 (US)

(74) Vertreter : Gaugel, Heinz, Dipl.-Ing.
Schönaicher Strasse 220
D-7030 Böblingen (DE)

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

EP 0 032 550 B1

## Beschreibung

Die Erfindung bezieht sich auf ein Verfahren zur Herstellung einer bipolaren, vertikalen PNP-Transistorstruktur, die mit Transistoren des komplementären Typs integrierbar ist, deren Kollektorzone in einem Silizium-Halbleitersubstrat, deren Basiszone in einer auf das Siliziumsubstrat aufgebrachten Silizium-Epitaxieschicht und deren Emitterzone in der Basiszone verwirklicht ist, wobei die Emitterzone in die Basiszone aus einer aufgebrachten, mittels Ionenimplantation dotierten polykristallinen Siliziumschicht durch Festkörperdiffusion von Störstellen eingebracht wird.

Es wurden bereits beträchtliche Bemühungen angestellt, auf einem gemeinsamen monolithischen Halbleitersubstrat Transistorpaare aus komplementären Transistoren zu verwirklichen. Im wesentlichen sind dabei zwei Probleme hervorgetreten. Einmal sind aufgrund der gegenüber der Beweglichkeit der Elektronen geringeren Beweglichkeit der Löcher die Eigenschaften des PNP-Transistors wesentlich schlechter als die Eigenschaften des NPN-Transistors. PNP-Transistoren weisen üblicherweise ein Beta von nicht mehr als 10 und eine Grenzfrequenz von nicht höher als etwa 500 MHz auf, wogegen NPN-Transistoren ein Beta von über 80 und eine Grenzfrequenz von über 3,5 GHz erreichen.

Obwohl Methoden zur Verfügung stehen, die Störstellenprofile in den Emitter-Basis- und Kollektorzonen komplementärer Transistoren definiert einzustellen, ist es doch bisher notwendig, die Charakteristiken des NPN-Transistors zu verschlechtern, um sie in Einklang mit den Charakteristiken des PNP-Transistors zu bringen. Zum anderen muß einer der Transistoren des komplementären Transistorpaares in ein dotiertes Sperrgebiet eingebracht werden. Bei Verwendung eines P-dotierten Halbleitersubstrates ist dann der PNP-Transistor mit einem N-dotierten Sperrgebiet zu umgeben. Das Vorsehen eines solchen Sperrgebietes bringt eine Reihe von Problemen mit sich, da dieses Sperrgebiet einen weiteren PN-Übergang bildet, der zu sekundären Transistoreffekten mit den bestehenden Transistorzonen führen kann.

Solche Methoden sind dem « IBM Technical Disclosure Bulletin », Vol. 22, Nr. 5, Okt. 1979, Seiten 1874 bis 1878 zu entnehmen. Auch andere bekannte Methoden zur Herstellung komplementärer Transistorstrukturen in einem gemeinsamen Halbleitersubstrat sind nicht in vollem Umfange zufriedenstellend. Eine Struktur aus zwei komplementären, bipolaren Transistoren ist beispielsweise aus « IBM Technical Disclosure Bulletin », Vol. 17, No. 1, June 1974, Seiten 21-22 bekannt. Die dort beschriebene Struktur und deren Herstellungsverfahren, beide nur andeutungsweise angegeben, erscheinen recht kompliziert zu sein, ohne daß die oben erwähnten Probleme sicher gelöst wären.

Außerdem ist in der US Patentschrift Nr. 3 730 786 ein Verfahren zur Herstellung eines Paares komplementärer Transistoren beschrieben. Bei diesem Verfahren dient eine hochdotierte N+-Zone in der Oberfläche eines Halbleitersubstrats als Sperrgebiet für den PNP-Transistor. Diese hochdotierte Zone diffundiert in nachfolgenden Verfahrensschritten in die aufgebrachte Epitaxieschicht aus. Durch Ionenmigration und Selbstdotierung entsteht das hochdotierte Sperrgebiet, dem die hochdotierte Subkollektorzone des PNP-Transistors überlagert ist.

Zwischen dem N+-dotierten Sperrgebiet und dem ebenfalls hochdotierten P+-Subkollektor des PNP-Transistors bildet sich ein PN-Übergang, der im Betrieb der Struktur zur Bildung eines parasitären NPN-Transistors führen kann.

Außerdem wird die Emitterzone des PNP-Transistors durch eine Bordiffusion hergestellt. PNP-Transistoren mit derartigen Emitterzonen sind bekannt dafür, schlechtere Eigenschaften als NPN-Transistoren aufzuweisen. Insbesondere haben derartige PNP-Transistoren üblicherweise ein Beta von unter 10. Die Grenzfrequenz dieser Transistoren ist verglichen mit der von NPN-Transistoren niedrig und liegt bei etwa 500 MHz.

In der Druckschrift « IEEE Journal of Solid-State Circuits », Vol. SC-11, No. 4, August 1976, ist auf den Seiten 491 bis 495 ein Verfahren zur Herstellung einer NPN-Transistorstruktur beschrieben, bei dem die Emitterzone in die Basiszone aus einer aufgebrachten, mittels Ionenimplantation von As dotierten, polykristallinen Siliziumschicht eingebracht wird.

Ein für eine PNP-Transistorstruktur optimales Dotierungsprofil der Emitterzone bei gleichzeitiger Vermeidung von Versetzungsfehlern in der Silizium-Epitaxieschicht ist mit den Angaben für die Dicke der polykristallinen Siliziumschicht, die Implantationsenergie der dort verwendeten Arsenionen und die Wärmebehandlung zur Bildung der Emitterzone nicht erreichbar.

Die Erfindung, wie sie in den Ansprüchen gekennzeichnet ist, löst die Aufgabe, eine PNP-Transistorstruktur anzugeben, die bei der Verwirklichung eines komplementären Transistorpaares auf einem gemeinsamen Halbleitersubstrat gewährleistet, daß die beiden Transistoren aneinander angeglichene Charakteristiken erhalten, wobei die P-Emitterzone der PNP-Transistorstruktur bei Vermeidung von Versetzungsfehlern in der die Zonen aufnehmenden Epitaxieschicht ein für die Transistorfunktion optimales Dotierungsprofil erhält und gewährleistet ist, daß das für den den PNP-Transistor vorzusehende Sperrgebiet zu keinen unerwünschten sekundären Transistoreffekten führt.

Zusammengefaßt bezieht sich die Erfindung auf gemeinsam integrierbare, komplementäre Transistorstrukturen, die aneinander angeglichene Eigenschaften und Charakteristiken aufweisen. Beim erfindungsgemäßen Verfahren zum Herstellen wird in die Oberfläche eines monokristallinen Halbleitersubstrats des P-Leitungstyps zunächst ein Sperrgebiet des N-Leitungstyps eingebracht. Nach einer

2

Wärmebehandlung, bei der die Störstellen des Sperrgebietes in das Halbleitersubstrat eingetrieben werden, wird eine Kollektorzone des PNP-Transistors in das Sperrgebiet eingebracht. Dabei kann man gleichzeitig in das Halbleitersubstrat Isolationszonen des P-Leitungstyps einbringen. Anschließend wird die Kollektorzone des NPN-Transistors in die Oberfläche des Halbleitersubstrats eingebracht. Diese Kollektorzone wird innerhalb eines isolierten Bereiches verwirklicht. Im nachfolgenden Verfahrensschritt wird auf die gesamte Oberfläche des Halbleitersubstrats eine Epitaxieschicht des N-Leitungstyps aufgewachsen.

Zur Herstellung abgesenkter dielektrischer Isolationszonen werden in einer Maskierungsschicht Fenster freigelegt, die direkt über den dotierten Isolationszonen des Halbleitersubstrats liegen. Die Oberfläche der Epitaxieschicht wird durch diese Fenster hindurch geätzt. Anschließend wird im Bereich dieser Fenster der verbleibende Teil der Epitaxieschicht thermisch oxidiert, wobei sich die angestrebten abgesenkten, dielektrischen Isolationszonen ergeben, die jeden der beiden Transistoren umgeben.

In einer weiteren Maskierungsschicht wird über der Kollektorzone des PNP-Transistors ein Fenster freigelegt, in dessen Bereich durch Diffusion eine Kollektorkontaktzone des P-Leitungstyps gebildet wird. Ein Fenster wird ebenfalls freigelegt über der Kollektorzone des NPN-Transistors, in dessen Bereich die Basiszone des P-Leitungstyps gebildet wird. Dabei kann natürlich durch ein weiteres Fenster über der Kollektorzone des PNP-Transistors eine Kollektorkontaktzone gebildet werden. Durch ein Fenster in der Maskierungsschicht wird in die Kollektorzone des PNP-Transistors die Basiszone des N-Leitungstyps eingebracht. Im Bereich der Basiszone der Transistoren werden dann Maskenfenster für die Emitterzone, die Kollektorkontaktzone und die Basiskontaktzonen gebildet, die dem P-Leitungstyp angehören und gleichzeitig eingebracht werden. Weitere Maskenfenster im Bereich der Basiszonen der Transistoren für eine Emitterzone, eine Kollektorkontaktzone und eine Basiskontaktzone werden erzeugt und, da sie dem P-Leitungstyp angehören, gleichzeitig eingebracht.

Um den PNP-Transistor mit verbesserten Eigenschaften auszustatten, wird seine P-dotierte Emitterzone vor dem ersten Eintreibprozeß dadurch gebildet, daß eine polykristalline Siliziumschicht auf den entsprechenden Oberflächenbereich der Basiszone aufgebracht wird. Die polykristalline Siliziumschicht wird mit Störstellen des P-Leitungstyps dotiert. Diese Störstellen werden anschließend in die Epitaxieschicht eingetrieben, wobei sich eine flache Emitterzone bildet, die keine Versetzung in der Gitterstruktur der Epitaxieschicht bewirkt oder aufweist.

Im folgenden wird die Erfindung anhand von in der Zeichnung dargestellten Ausführungsbeispielen näher erläutert. Es zeigen :

Figuren 1-17 eine vereinfachte, nicht maßstabsgerechte Schnittansicht eines Paares komplementärer Transistoren in verschiedenen, aufeinanderfolgenden Stufen des erfindungsgemäßen Herstellungsverfahrens,

Figur 8 die Dotierungsprofile des PNP-Transistors von Figur 7,

Figur 9 die Dotierungsprofile des NPN-Transistors von Figur 7,

Figuren 10-13 eine vereinfachte, nicht maßstabsgerechte Schnittansicht eines erfindungsgemäßen PNP-Transistors in verschiedenen, aufeinanderfolgenden Stufen des Herstellungsverfahrens,

Figuren 14-16 eine vereinfachte, nicht maßstabsgerechte Schnittansicht eines erfindungsgemäßen PNP-Transistors in verschiedenen, aufeinanderfolgenden Stufen des Herstellungsverfahrens, wobei eine Methode mit einer polykristallinen Doppelschicht angewandt ist,

Figuren 17-22 eine Darstellung verschiedener mit der Erfindung zusammenhängender Parameter,

Figur 23 eine den Vergleich der Emitterstruktur des erfindungsgemäßen PNP-Transistors mit der bekannter PNP-Transistoren kennzeichnenden Darstellung und

Figur 24 weitere im Zusammenhang mit der Erfindung stehende Parameter.

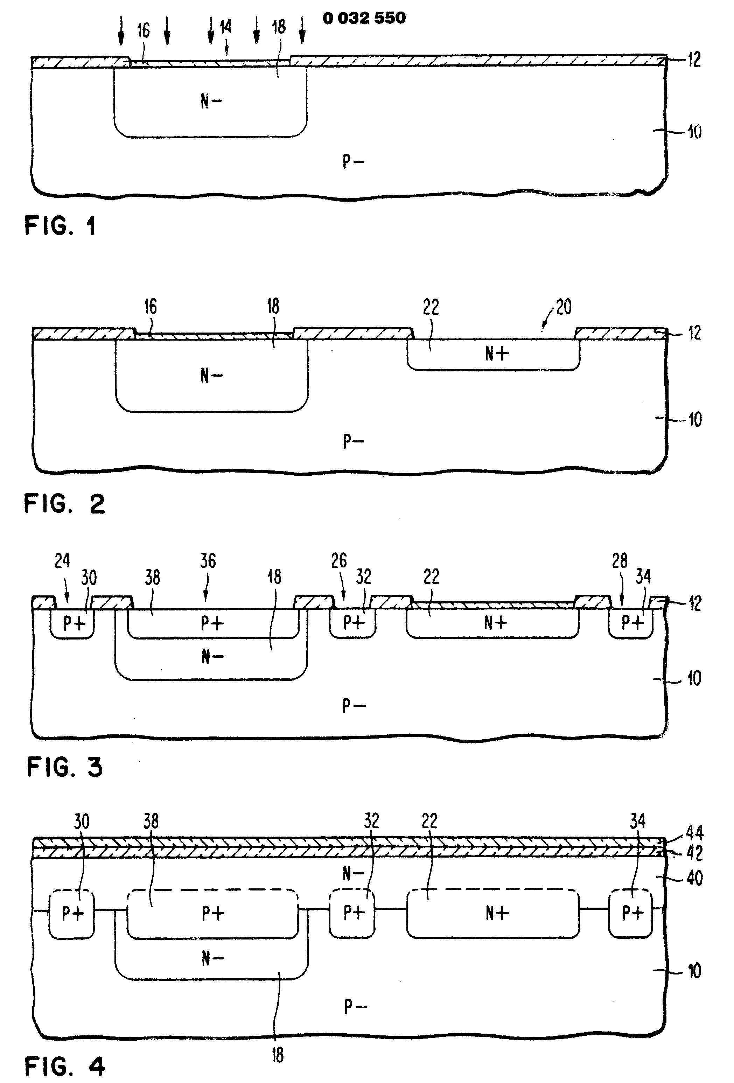

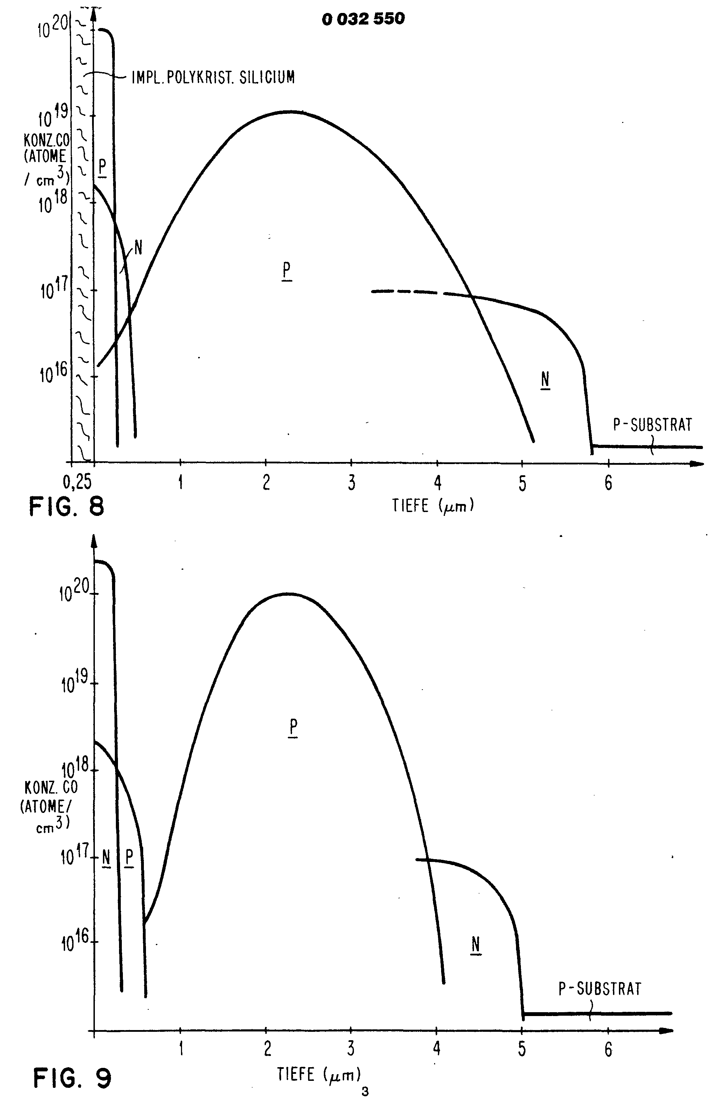

Die ein bevorzugtes Ausführungsbeispiel der erfindungsgemäßen Transistorstruktur wiedergebenden Fign. 1 bis 7 werden unter Berücksichtigung von bei der Herstellung wichtiger Prozeßparameter beschrieben. Die in den Fign. 8 und 9 angebenen Dotierungsprofile geben ein wesentliches Merkmal der Erfindung wieder, d. h., die Beziehung zwischen den Störstellenkonzentrationen des Sperrgebietes und der Subkollektorzone, die in das Sperrgebiet eingebracht ist, und zwar insbesondere der Störstellenkonzentrationen am gebildeten PN-Übergang.

Beim betrachteten Ausführungsbeispiel wird von einem P-dotierten Halbleitersubstrat aus Silicium ausgegangen. Zur Herstellung von NPN-Transistoren verwendet man natürlich P-dotierte Halbleitersubstrate. NPN-Transistoren werden bevorzugt verwendet, da sie im Vergleich zu PNP-Transistoren wesentlich verbesserte Eigenschaften aufweisen. Es ist jedoch darauf hinzuweisen, daß im Rahmen der Erfindung auch von einem N-dotierten Halbleitersubstrat ausgegangen werden kann, ohne die durch die Erfindung erzielten Vorteile zu verlieren.

Bei der Beschreibung der einzelnen Strukturen sind mehrere Prozeßschritte, die sich mit dem Aufbringen, Belichten und Entwickeln von Photolack befassen, nicht im einzelnen berücksichtigt, da diese allgemein bekannt sind.

Wie Fig. 1 zeigt, dient als Ausgangsmaterial ein P-dotiertes Halbleitersubstrat 10. Der spezifische Widerstand des Halbleitersubstrats liegt im Bereich von 10 bis 20 Ohm/cm$^2$. Durch einen Oxidationsprozeß wird auf die Oberfläche des Substrats 10 eine Siliciumdioxidschicht 12 in einer Dicke von etwa 350 nm aufgebracht. Die Siliciumdioxidschicht 12 wird geätzt, um das Fenster 14 zu erzeugen, in dessen Bereich die Oberfläche des Substrates 10 freigelegt wird. Durch Reoxidation wird die Oberfläche des Halbleitersubstrats 10 mit einer dünnen Dioxidschicht 16 belegt, die eine Dicke von etwa 30 nm aufweist. Im Bereich des Fensters 14 wird nunmehr durch Ionenimplantation ein N-dotiertes Sperrgebiet 18 eingebracht. Wesentlich ist, daß die Ionenimplantation mit hoher Energie aber niedriger Dosis durchgeführt wird. Vorzugsweise wählt man eine Energie im Bereich von etwa 200 bis etwa 400 keV bei einer Dosis von etwa $1 \times 10^{14}$ bis $1 \times 10^{15}$ Ionen/cm$^2$.

Durch die hohe Implantationsenergie gelangen die Ionen bis zu einer Tiefe von etwa 0,5 µm in die Oberfläche des Halbleitersubstrats. In einem anschließenden Erwärmungsprozeß werden die Ionen weiter in das Halbleitersubstrat eingetrieben. Ein solcher Erwärmungsprozeß erfolgt beispielsweise bei einer Temperatur von etwa 1 100 °C und einer Dauer von etwa 300 bis 500 Minuten in einer inerten Atmosphäre von Argon oder Stickstoff. Nach diesem Erwärmungsprozeß erstreckt sich das Sperrgebiet 18 bis zu einer Tiefe von etwa 3,5 µm in das Halbleitersubstrat. In der Oxidschicht 12 wird ein Maskenfenster 20 geöffnet, durch das ein N$^+$-Subkollektor 22 des NPN-Transistors eindiffundiert wird. Dabei kann Arsen in einer Kapseldiffusion bei 1 050 °C und einer Dauer von 150 Minuten als Störstellenmaterial verwendet werden. Es bildet sich eine Oberflächenkonzentration von $2,5 \times 10^{20}$ Ionen/cm$^3$, ein Schichtwiderstand von 9,83 Ohm/cm und eine anfängliche Zonentiefe von etwa 1 µm.

Nach dem Eintreiben liegt die Störstellenkonzentration des Sperrgebietes am Übergang zur Subkollektorzone im Bereich von etwa $1 \times 10^{16}$ bis etwa $5 \times 10^{17}$ Atome/cm$^3$. Wie sich leicht aus der Fig. 8 ergibt, dient der Eintreibprozeß auch der Verteilung der Ionen, so daß sich ein relativ flaches Dotierungsprofil ergibt, das kein Konzentrationsmaximum über der Konzentration an der Grenzfläche aufweist. Vorzugsweise liegt die maximale Konzentration des Sperrgebietes im Bereich von etwa $1 \times 10^{16}$ bis etwa $5 \times 10^{17}$ Atome/cm$^3$. Die Störstellenkonzentration des Sperrgebietes ausgehend von der Grenzfläche zur Subkollektorzone liegt also zwischen der Störstellenkonzentration des P-Substrates und der maximalen Konzentration der P$^+$-Subkollektorzone und liegt vorzugsweise zwischen etwa $1 \times 10^8$ bis etwa $1 \times 10^{20}$ Atome/cm$^3$. Ein derart ausgestaltetes Sperrgebiet ist ein wesentliches Merkmal der Erfindung.

Nach einer Reoxidation, bei der das Maskenfenster über der Subkollektorzone 22 geschlossen wird, werden Maskenfenster 24, 26 und 28 in der Oxidschicht 12 geöffnet. Im Bereich dieser Fenster werden die P$^+$-Isolationszonen 30, 32 und 34 eindiffundiert. Gleichzeitig wird das Maskenfenster 36 geöffnet, in dessen Bereich die Subkollektorzone 38 des PNP-Transistors eindiffundiert wird. Die gleichzeitig stattfindende Diffusion durch die Maskenfenster 24, 26, 28 und 36 kann als Kapseldiffusion mit Bor als Störstellenmaterial bei einer Temperatur von 1 050 °C und einer Dauer von 100 Minuten ausgeführt werden. Dabei bildet sich ein Schichtwiderstand von 10 Ohm/cm$^2$ und eine anfängliche Übergangstiefe von 2,1 µm. Durch einen Reoxidationsprozeß werden die Maskenfenster wieder geschlossen. Die bereits gebildeten Dotierungsprofile werden während dieses und weiterer einer Oxidation dienenden Erwärmungsprozesse weiter verschoben.

Im nächsten Prozeßschritt werden sämtliche Oxidschichten entfernt und anschließend eine N-dotierte Epitaxieschicht 40 auf das Halbleitersubstrat aufgebracht (Fig. 4). Die Epitaxie wird bei einer Temperatur von 1 100 °C ausgeführt, wobei eine Schichtdicke von 2 µm und ein spezifischer Widerstand von 0,3 bis 0,5 Ohm/cm$^2$ erreicht wird. Während des Epitaxieprozesses diffundieren die Subkollektorzonen 22, die Subkollektorzone 38 und die Isolationszonen 30, 32 und 34 in die Epitaxieschicht 40 aus. Aufgrund der vergleichbaren Störstellenkonzentrationen im Sperrgebiet 18 und in der Epitaxieschicht 40 erfolgt, wenn überhaupt, nur eine geringfügige Ausdiffusion des Sperrgebietes 18 in die Epitaxieschicht 40.

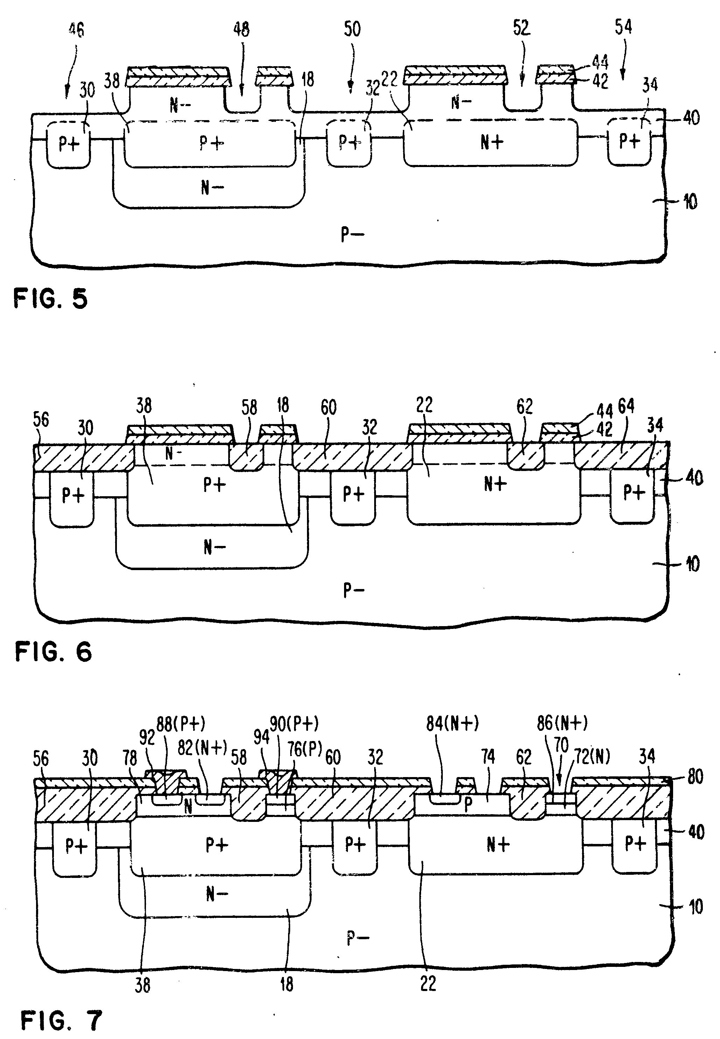

Auf die Epitaxieschicht 40 wird eine Oxidschicht 42 mit einer Dicke von etwa 150 nm und darüber eine Siliciumnitridschicht 44 mit einer Dicke von etwa 100 nm aufgebracht. In der Nitridschicht 44 und der Oxidschicht 42 werden Maskenfenster 46, 48, 50, 52 und 54 geöffnet, um dort die in Fig. 6 gezeigten Isolationszonen 56, 58, 60, 62 und 64 aus abgesenkten Oxidbereichen zu bilden. Nach dem Öffnen der Maskenfenster wird in deren Bereich Silicium bis zu einer Tiefe von etwa 390 nm abgeätzt. In einem anschließenden Oxidationsprozeß wird im Bereich der Maskenfenster das Silicium oxidiert, so daß die abgeätzten Bereiche mit Siliciumdioxid aufgefüllt werden und die angestrebten Isolationszonen bilden. Die Oxidation findet beispielsweise in einer Sauerstoffatmosphäre bei einer Temperatur von 1 000 °C und einer Dauer von 300 min statt, wobei sich eine Oxiddicke von etwa 1,05 nm ausbildet.

Die Kollektorverbindungszone, der Kollektorkontakt, der Basiskontakt und die Emitterzone für den NPN- und den PNP-Transistor werden in den nachfolgenden Prozeßschritten erzeugt, so daß sich die in Fig. 7 dargestellte Struktur ergibt. Zunächst wird die Siliciumnitridschicht 44 von der Struktur gemäß Fig. 6 entfernt. In der Oxidschicht wird ein Maskenfenster 70 geöffnet, in dessen Bereich die Kollektorverbindungszone 72 des NPN-Transistors gebildet wird. Diese N$^+$-Zone 73 kann durch Kapseldiffusion oder Ionenimplantation hergestellt werden. Anschließend wird durch Oxidation das Maskenfenster 70 geschlossen und ein sich über das Gebiet 74 erstreckendes Maskenfenster freigelegt, das die Basiszone des NPN-Transistors definiert.

Gleichzeitig wird ein Maskenfenster geöffnet, in dessen Bereich die Kollektorverbindungszone 76 des PNP-Transistors einzubringen ist. Die Basiszone 74 und die Kollektorverbindungszone 76 werden gleichzeitig durch Diffusion oder Ionenimplantation von Bor verwirklicht. Im Falle einer Ionenimplantation wird eine Energie von etwa 150 keV bei einer Dosis von etwa $5 \times 10^{13}$ Ionen/cm$^2$ angewandt. Werden irgendwelche dotierte Zonen durch Ionenimplantation eingebracht, so geschieht dies durch eine Schutzschicht aus Oxid in einer Dicke von etwa 30 nm. Die genannten Maskenfenster werden durch Reoxidation wieder geschlossen. Als nächstes wird ein Maskenfenster zur Herstellung der Basiszone 78 des PNP-Transistors freigelegt. Die Basiszone 78 wird durch Ionenimplantation von Phosphor bei einer Energie von 70 bis 100 keV und einer Dosis von etwa $2 \times 10^{14}$ Ionen/cm$^2$ gebildet.

Anschließend wird eine Siliciumnitridschicht 80 in einer Dicke von etwa 100 nm auf die Oberfläche der bestehenden Struktur aufgebracht. Dann werden Maskenfenster für den Basiskontakt 82 des PNP-Transistors, die Emitterzone 84 des NPN-Transistors und den Kollektorkontakt 86 des NPN-Transistors gebildet. Der Basiskontakt 82, die Emitterzone 84 und der Kollektorkontakt 86 werden entweder durch Diffusion oder Ionenimplantation von Arsen verwirklicht. Eine Ionenimplantation wird vorzugsweise bei einer Energie von etwa 50 keV und einer Dosis von etwa $1 \times 10^{16}$ Ionen/cm$^2$ durchgeführt.

Weiterhin werden Maskenfenster geöffnet, die die Emitterzone 88 und die Kollektorkontaktzone 90 des PNP-Transistors definieren.

In einem anschließend noch näher beschriebenen Verfahren wird die P-Emitterzone des PNP-Transistors vor einer letzten Eintreib-Wärmebehandlung dadurch gebildet, daß auf den entsprechenden, freigelegten Bereich der Basiszone eine polykristalline Siliciumschicht aufgebracht wird. Die polykristalline Siliciumschicht wird durch Ionenimplantation mit P-Störstellen dotiert. Anschließend wird die Struktur Bedingungen ausgesetzt, bei denen die implantierten Ionen aus der polykristallinen Siliciumschicht in die Epitaxieschicht eingetrieben werden und dort die Emitterzone bilden. Bei diesem Verfahren treten Versetzungen der Gitterstruktur der Epitaxieschicht nicht auf. Obwohl für die Funktionstüchtigkeit der komplementären Halbleiterstruktur nicht ausschlaggebend, kann die Kollektorkontaktzone 90 ebenfalls durch Ausdiffusion von in die polykristalline Siliciumschicht implantierten Störstellen gebildet werden. Dies geschieht gleichzeitig mit der Herstellung der Emitterzone 88. Das Eintreiben der Emitterzone 88 und der Kollektorkontaktzone 90 erfolgt in einem gemeinsamen Prozeß. Die verbleibenden polykristallinen Siliciumschichten 92 und 94 können Teil der Struktur bleiben, indem sie die Verbindung zu der auf der Oberfläche aufzubringenden Metallisierung herstellen.

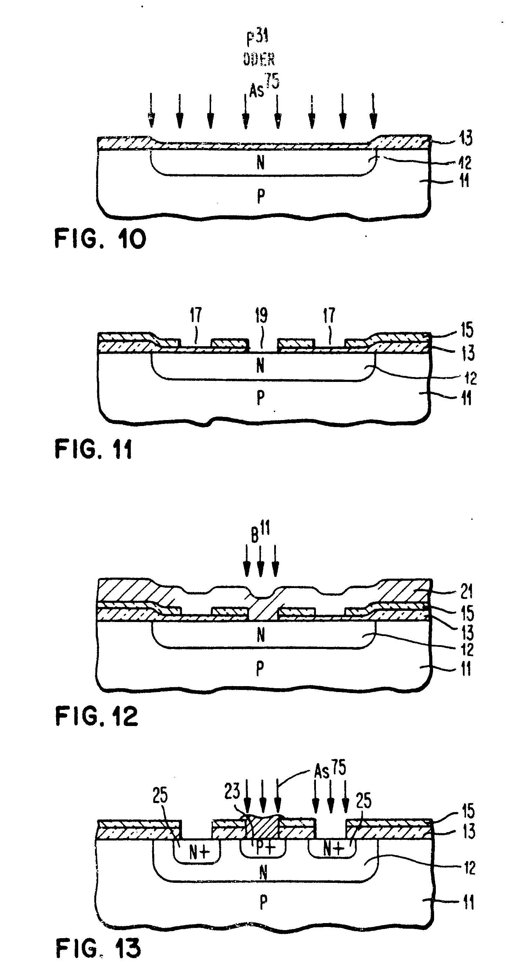

Im folgenden wird ein bevorzugtes Verfahren zur Herstellung der Emitterzone des PNP-Transistors anhand der Fign. 10 bis 13 beschrieben. Eine Basiszone 12 und eine Subkollektorkontaktzone (nicht dargestellt) sind in der beschriebenen Weise in ein monokristallines Halbleitersubstrat 11, das in Fig. 10 dargestellt ist, eingebracht. Während der hierzu erforderlichen Diffusion bildet sich auf der Basiszone 12 eine Siliciumdioxidschicht 13. Anschließend wird auf die Siliciumdioxidschicht 13 eine Siliciumnitridschicht 15 aufgebracht. Durch Anwendung der üblichen Photoätztechnik werden in der Siliciumnitridschicht 15 Maskenfenster 17 und 19 für den Basiskontakt und die Emitterzone erzeugt. Das Maskenfenster 19 für die Emitterzone wird in einem Ätzprozeß durch die Siliciumdioxidschicht 13 hindurch freigelegt. Anschließend wird auf die gesamte Oberfläche der Struktur eine polykristalline Siliciumschicht 21 aufgebracht. Die polykristalline Siliciumschicht 21 wird durch Ionenimplantation, deren spezifische Parameter noch angegeben werden, mit P-Störstellenmaterial dotiert. Als Störstellenmaterial verwendet man vorzugsweise Bor. Die polykristalline Siliciumschicht wird dann so abgeätzt, daß lediglich die Struktur einer Emitterelektrode, wie es in Fig. 13 dargestellt ist, zurückbleibt. Durch eine Wärmebehandlung, beispielsweise auch durch Laserbestrahlung, diffundieren Boratome aus der polykristallinen Schicht in die Basiszone 12 und bilden dort die P$^+$-dotierte Emitterzone 23.

Im nächsten Verfahrensschritt wird der im Bereich der Maskenfenster 17 liegende Teil der Siliciumdioxidschicht 13 abgeätzt, so daß die Oberfläche des Substrates 11 freigelegt wird. Durch Implantation von einer N-Leitfähigkeit hervorrufende Ionen, beispielsweise AS$^{75}$ oder P$^{31}$ werden die Basiskontaktzonen 25 gebildet. Schließlich wird die Struktur in bekannter Weise zur Herstellung der leitenden Verbindungen metallisiert. Da das dotierte polykristalline Silicum eine ausreichende Leitfähigkeit aufweist, um gute ohmsche Kontakte mit der Emitterzone 23 zu bilden, kann das restliche polykristalline Silicium über der Emitterzone als Emitterelektrode verbleiben. Selbstverständlich kann auch eine metallische Elektrode gebildet werden.

Das Dotierungsprofil eines auf die beschriebene Weise hergestellten PNP-Transistors ist in Fig. 8 angegeben. Dort ist auch das Dotierungsprofil des Sperrgebietes 18 eingezeichnet. Es zeigt sich, daß die Emitterzone sehr flach ist und sich nur bis zu einer Tiefe von etwa 200 nm erstreckt. Der Konzentrationsgradient der Emitterzone ist extrem steil, was anzustreben ist. Die Werte für die Stromverstärkung beta des erfindungsgemäßen PNP-Transistors sind im Vergleich zu den bekannten PNP-Transistoren extrem hoch. Werte von über 200 im Vergleich zu Werten unter 10 konventioneller PNP-Transistoren werden erreicht. Die Trennfrequenz (f$^t$) ist ebenfalls hoch, d. h., 3,6 GHz im Vergleich zu 500 MHz für konventionelle PNP-Transistoren.

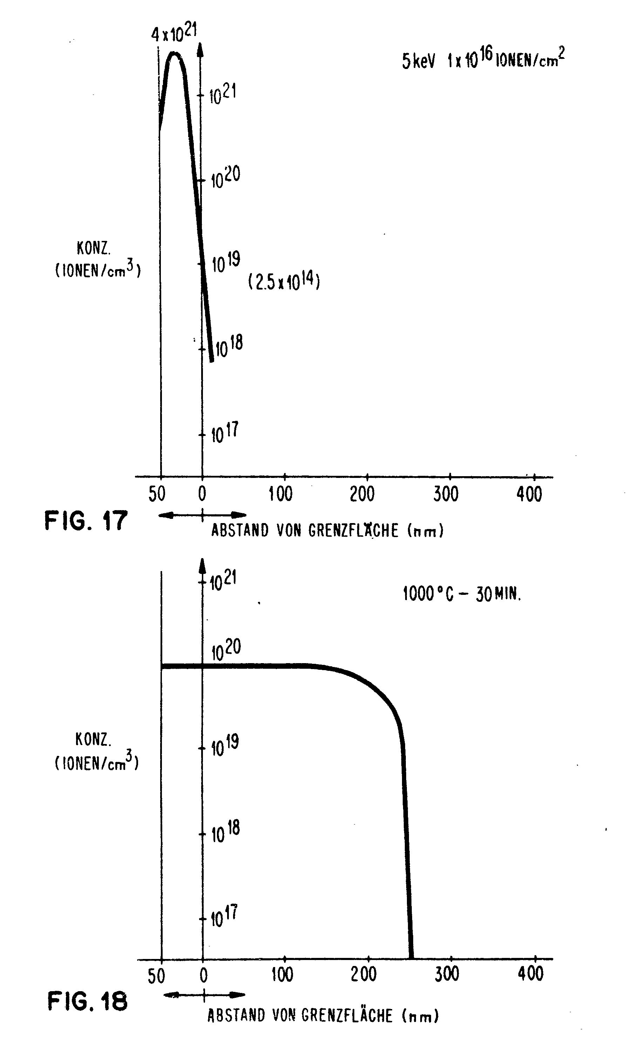

Der vertikale, bipolare PNP-Transistor gemäß der Erfindung weist eine Emitterzone auf mit einer Konzentration von mindestens $1 \times 10^{19}$ Ionen/cm$^3$, die sich bis zu einer Tiefe von mindestens 200 nm erstreckt, und einer Konzentration von weniger als etwa $1 \times 10^{16}$ Ionen/cm$^3$, die sich bis zu einer Tiefe von 350 nm nach dem Eintreiben erstreckt. Vorzugsweise weist die Emitterzone eine Störstellenkonzentration von mindestens $5 \times 10^{19}$ Ionen/cm$^3$ bis zu einer Tiefe von mindestens 150 nm und eine Störstellenkonzentration von weniger als etwa $1 \times 10^{17}$ in einer Tiefe von etwa 300 nm auf. Die Charakteristik der Störstellenverteilung der P-dotierten Emitterzone des erfindungsgemäßen Transistors ist, wie auch die Fign. 18, 20 und 22 zeigen, gekennzeichnet durch eine gleichförmige Konzentration in der Nähe der Oberfläche des Halbleitersubstrats. Diese Konzentration erstreckt sich nur über eine geringe Entfernung von der Oberfläche weg und fällt dann sehr steil ab. Diese Charakteristik ist für die beträchtliche Verbesserung des PNP-Transistors im Hinblick auf Verstärkungs- und Frequenzverhalten von besonderer Bedeutung.

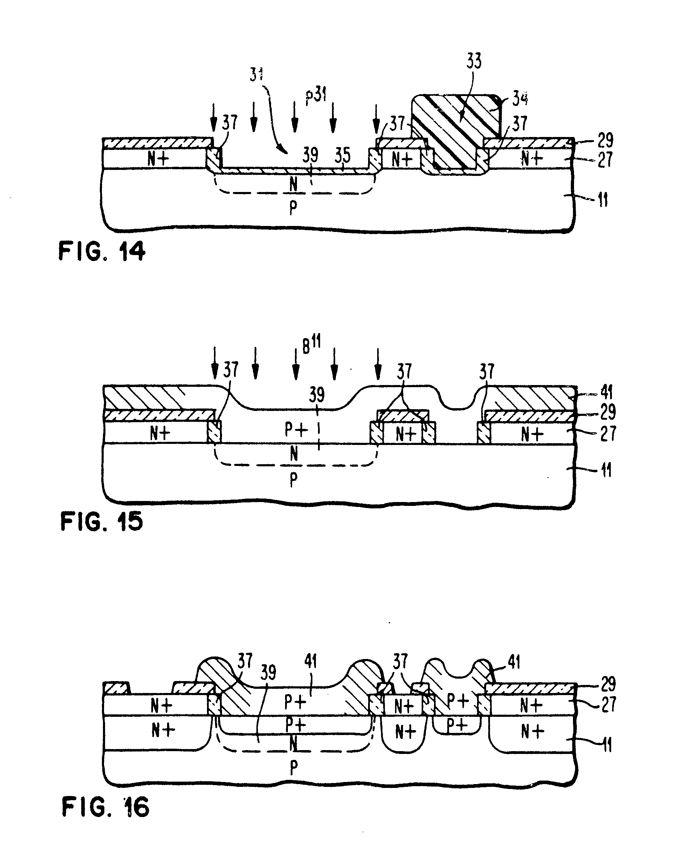

Das erfindungsgemäße Verfahren ist auch in Verbindung mit der Herstellung von PNP-Transistoren durch die sogenannte Doppel-Polysilicium-Technik anwendbar. Eine solche Methode ergibt sich aus den Fign. 14 bis 16. Im betrachteten Beispiel wird eine polykristalline Siliciumschicht 27 auf ein monokristallines Siliciumsubstrat 11 aufgebracht. Die polykristalline Siliciumschicht 27 wird durch Ionenimplantation oder ein anderes geeignetes Verfahren N-dotiert. Auf die polykristalline Siliciumschicht 27 wird eine pyrolytische Siliciumdioxidschicht 29 aufgebracht. Ein eine intrinsische Basiszone definierendes Maskenfenster 31, das auf die nachfolgend einzubringende Emitterzone ausgerichtet ist, wird in der Siliciumdioxidschicht 29 und in der polykristallinen Siliciumschicht 27 geöffnet. Ebenfalls wird ein Maskenfenster für die Kollektorkontaktzone 33 geöffnet und mit einer Photolackschicht 34 abgedeckt, wie es in Fig. 14 dargestellt wird.

Nach dem Öffnen der beiden Maskenfenster 33 und 31 für die Kollektorkontaktzone und für die intrinsische Basiszone wird die Struktur einem Reoxidationsprozeß ausgesetzt, bei dem eine Siliciumdioxidschicht 35 gebildet wird. Da N-dotiertes polykristallines Silicium etwa 4 × schneller oxidiert als das niedrig dotierte monokristalline Silicium des Substrates 11, bildet die an den zweiten Enden des polykristallinen Siliciums gebildete Oxidschicht 37 die Begrenzung für den zu bildenden Emitter-Basisübergang. D. h., der Basis-Emitterübergang endet unterhalb der thermischen Siliciumdioxidschicht. Nach folgendem Prozeß wird die N-dotierte intrinsische Basiszone 39 durch Ionenimplantation von beispielsweise $P^{31}$ oder $AS^{75}$ gebildet.

Nunmehr wird eine zweite polykristalline Siliciumschicht 41 auf die Struktur aufgebracht, wie es in Fig. 15 dargestellt ist. Diese zweite polykristalline Siliciumschicht wird mit $B^{11}$ implantiert. Die nachfolgenden Prozeßschritte entsprechen den Prozeßschritten, die in Verbindung mit den Fign. 10 bis 13 beschrieben wurden. Die weiteren Prozeßschritte ergeben sich aus den Fign. 15 und 16.

Eine erfindungsgemäße, P-dotierte Emitterzone mit den bereits beschriebenen Charakteristiken kann man erzielen, wenn die Dicke der polykristallinen Siliciumschicht, die Ionendosis, die Implantationsenergie und die gesamten Zeit-Temperatur-Bedingungen, denen die Transistorstruktur nach der Ionenimplantation noch auszusetzen ist, berücksichtigt werden.

Ganz allgemein kann festgestellt werden, daß wenn die Implantation von Bor oder einem anderen P-Störstellenmaterial in die polykristalline Siliciumschicht unter Bedingungen stattfindet, bei denen die Störstellenkonzentration an der Grenzfläche zwischen der polykristallinen und der monokristallinen Siliciumschicht geringer ist als das Konzentrationsmaximum einer kritischen Dosis, daß dann die während der Ionenimplantation eingebrachten Schäden nicht ausreichen, um eine Störung in der monokristallinen Siliciumschicht herbeizuführen. Werden zusätzlich die erfindungsgemäßen Dotierungsbedingungen eingehalten, so erhält man nach dem Eintreibprozeß eine sehr flache, hochdotierte Emitterzone mit einem extrem steilen Konzentrationgradienten, was Voraussetzungen für optimale Eigenschaften aufweisende Emitterzonen von PNP-Transistoren sind.

Es bleibt festzuhalten, daß die bei der Implantation der Ionen des P-Leitungstyps aufgewandte Dosis über der kritischen Dosis liegt, von der man weiß, daß sie irreparable Versetzungsfehler hervorruft. Das bedeutet, daß beim erfindungsgemäßen Verfahren zwar eine Gesamtdosis aufgewandt wird, die über einer bisher als kritisch angesehenen Dosis liegt, daß aber die weiteren Umstände des Implantationsprozesses gewählt sind, daß Schäden verhindert und ein extrem vorteilhafter Störstellenkonzentrationsverlauf in einer flachen Emitterzone erzielt wird.

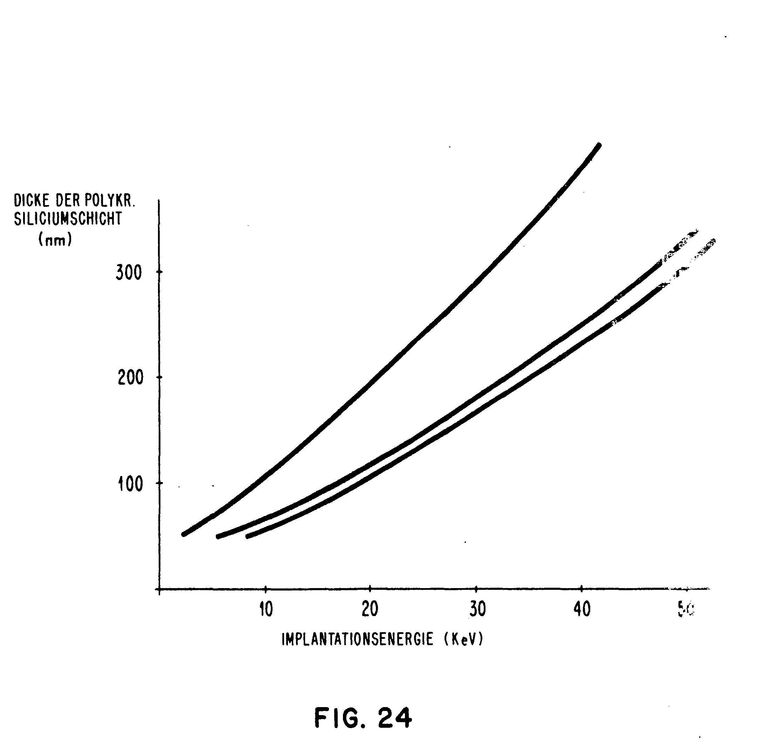

Die kritische Dosis für Störstellen des P-Leitungstyps liegt bei etwa $1 \times 10^{15}$ Ionen/cm². Die beim erfindungsgemäßen Verfahren nutzbare Dosis liegt im Bereich von etwa $1 \times 10^{16}$ bis etwa $1 \times 10^{17}$ Ionen/cm². Die Implantationsenergie, mit der die Störstellen in die polykristalline Siliciumschicht implantiert werden, hängt von der Dicke der Polykristallinen Schicht ab. Der Zusammenhang zwischen Implantationsenergie und Dicke der polykristallinen Siliciumschicht ergibt sich aus der Darstellung in Fig. 24, wo die obere Kurve den minimalen Energiepegel für eine bestimmte Dicke der polykristallinen Siliciumschicht angibt. Die mittlere Kurve gibt den optimalen Energiepegel und die untere Kurve den maximalen Energiepegel an.

Nach der Implantation des P-Störstellenmaterials in die polykristalline Siliciumschicht, wird das Störstellenmaterial durch eine Wärmebehandlung in die monokristalline Schicht eingetrieben. Die Wärmebehandlung erfolgt vorzugsweise bei einer Temperatur von etwa 900 bis etwa 1 100 °C, bei einer Dauer von etwa 90 min bei der niedrigeren Temperatur und bei einer Dauer von 2 min bei der höheren Temperatur. Zur einfacheren Steuerung der Wärmebehandlung führt man sie vorzugsweise bei einer Temperatur von etwa 950 °C bis etwa 1 000 °C durch, wobei die Einwirkzeit der niedrigeren Temperatur etwa 60 min und die der höheren Temperatur etwa 45 min beträgt. Eine weitere vorzugsweise angewandte Wärmebehandlung besteht darin, daß eine Erwärmung auf etwa 1 000 °C während einer Dauer von 30 Minuten erfolgt. Auch andere equivalente Zeit-Temperatur-Verhältnisse sind wählbar. Dabei ist darauf hinzuweisen, daß alle Wärmebehandlungen zusammen, denen die Transistorstruktur im Laufe des Herstellungsverfahrens auszusetzen ist, das Equivalent der angegebenen Werte nicht überschreiten. Sind andere durch Ionenimplantation hergestellte Zonen durch eine Wärmebehandlung einzutreiben, beispielsweise Basiskontaktzonen, so sollte diese Wärmebehandlung vor oder gleichzeitig mit dem Eintreiben der Emitterzone erfolgen.

Im folgenden werden anhand der Fign. 17 bis 22 verschiedene, der Erfindung zugrundeliegende Kenngrößen für unterschiedliche Dicken der polykristallinen Siliciumschichten angegeben. Wie der Fig. 17 zu entnehmen ist, wird eine polykristalline Siliciumschicht in einer Dicke von 50 nm aufgebracht. Es erfolgt eine Implantation von Bor mit einer Dosis von $1 \times 10^{16}$ Ionen/cm$^2$. Die Implantationsenergie beträgt 5 keV. Unter diesen Voraussetzungen ergibt sich die in Fig. 17 dargestellte Verteilung der Ionen in der polykristallinen Siliciumschicht. Nach der Implantation wird das Bor in die monokristalline Siliciumschicht eingetrieben, um dort die Emitterzone zu bilden. Dies geschieht während einer Wärmebehandlung bei einer Temperatur von 1 000 °C und einer Dauer von 30 min. Die sich in der Emitterzone ergebende Störstellenverteilung ist der Fig. 18 zu entnehmen. Es zeigt sich, daß die Störstellenkonzentration bis zu einer Tiefe bzw. einem Abstand von der Grenzfläche von etwa 200 nm gleichmäßig etwa $10^{20}$ Ionen/cm$^2$ beträgt.

Der Fig. 17 ist zu entnehmen, daß die Störstellenkonzentration an der Grenzfläche zwischen der polykristallinen Siliciumschicht und der monokristallinen Siliciumschicht etwa $10^{19}$ Ionen/cm$^3$ beträgt. Zur Erzielung einer Gauss'schen Störstellenverteilung mit einem Maximum bei etwa $10^{19}$ Ionen/cm$^3$ ist eine Dosis von etwa $2,5 \times 10^{14}$ Ionen/cm$^2$ und eine Implantationsenergie von etwa $2,5 \times 10^{14}$ Ionen/cm$^2$ und eine Implantationsenergie von etwa 5 keV erforderlich. Die genannte Dosis liegt unterhalb der kritischen Dosis von $1 \times 10^{15}$ Ionen/cm$^2$. Damit erfüllt das Ionenimplantationsverfahren, durch das die Störstellenverteilung gemäß Fig. 17 erzielt wird, die grundsätzlichen Erfordernisse, wie sie durch die Erfindung gegeben sind, nämlich, daß die Konzentration der Ionen an der Grenzfläche geringer sein sollte als die, die durch eine kritische Dosis erreicht wird, während Verteilungsmaximum an der Grenzfläche auftritt.

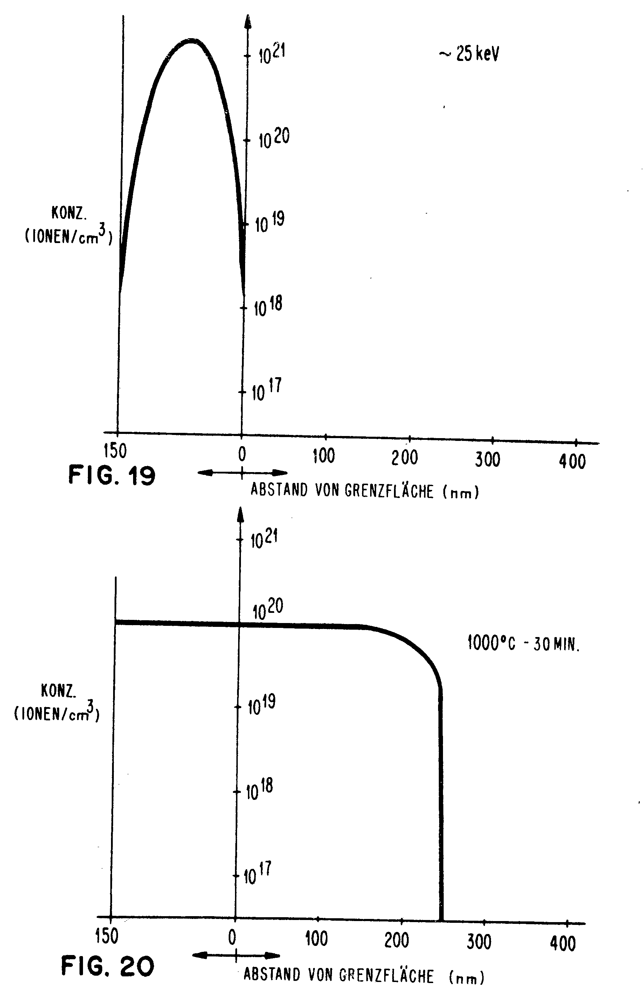

In den Fign. 19 und 20 ist die Störstellenverteilung nach der Ionenimplantation und nach dem Eintreiben für eine polykristalline Siliciumschicht eine Dicke von 150 nm aufgezeichnet. Die Implantationsenergie beträgt 25 keV bei einer Dosis von $10^{16}$ Ionen/cm$^2$. Das Eintreiben erfolgt bei einer Temperatur von 1 000 °C und einer Dauer von 30 min.

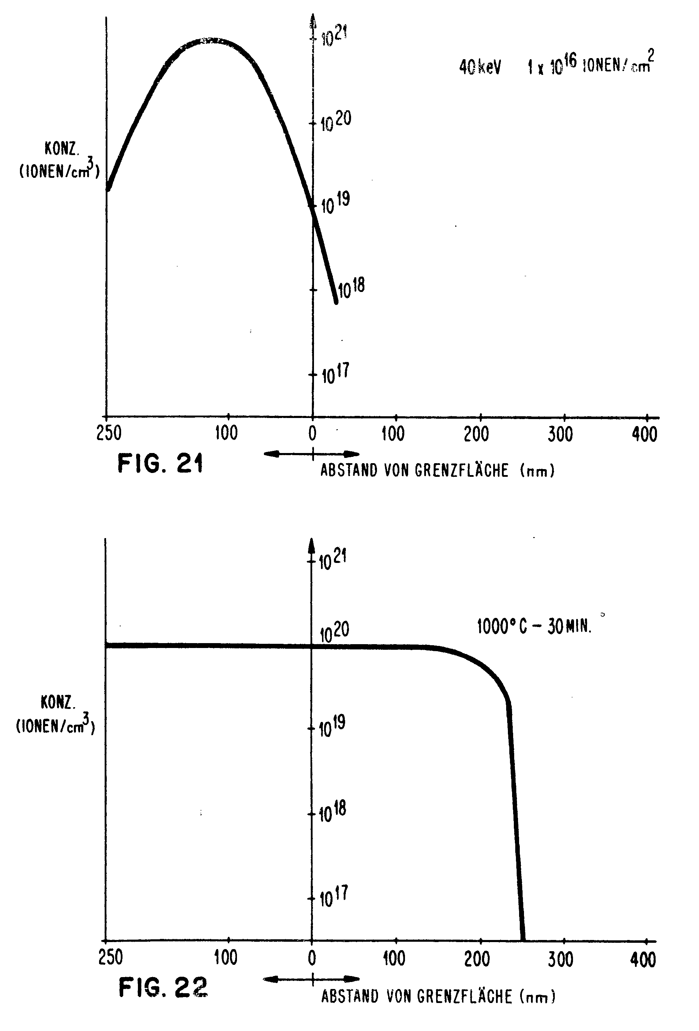

Die Fign. 21 und 22 zeigen die Störstellenverteilung (Konzentration) nach der Ionenimplantation und dem Eintreiben für eine polykristalline Siliciumschicht mit der Dicke von 250 nm. Die Implantationsenergie beträgt 40 keV bei einer Dosis von $10^{16}$ Ionen/cm$^2$. Das Eintreiben wird bei einer Temperatur von 1 000 °C und einer Dauer 30 min durchgeführt.

Den Fign. 17 bis 22 ist zu entnehmen, daß trotz unterschiedlicher Dicke der polykristallinen Siliciumschicht die Emitterzone etwa die gleiche maximale Störstellenkonzentration und etwa die gleiche Tiefe aufweist. Das zeigt, daß die gesamte Ionenaufnahme der polykristallinen Siliciumschicht unabhängig von der Dicke dieser Schicht ungefähr equivalent ist. Bei reduzierter Dicke der polykristallinen Siliciumschicht ist dem entsprechend das Maximum der Störstellenkonzentration erhöht.

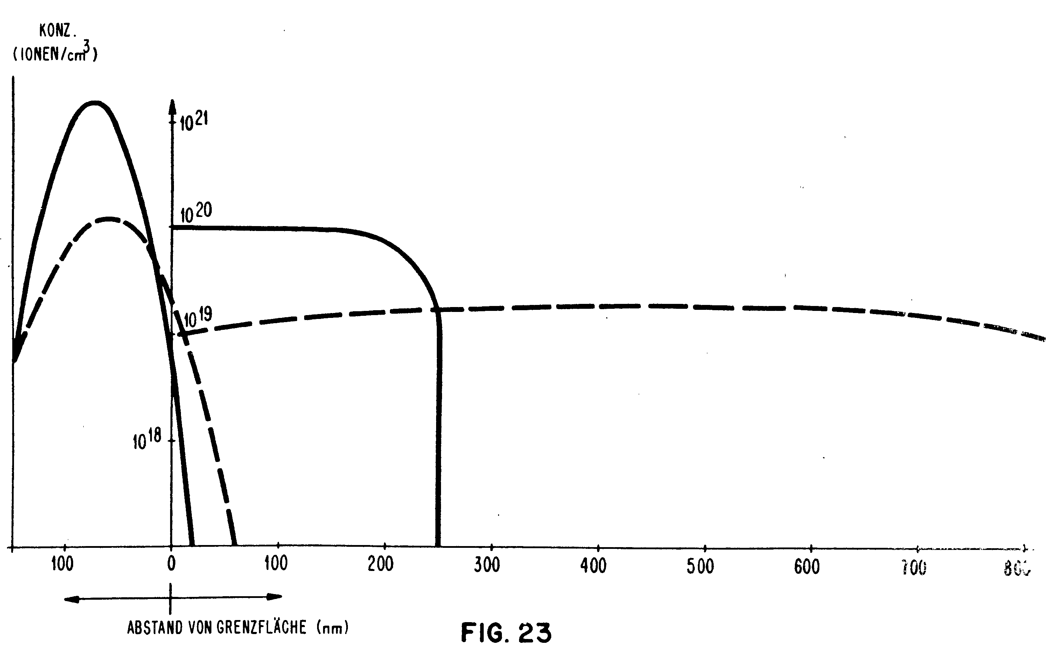

Die Fig. 23 zeigt die unterschiedlichen Verhältnisse bei der Erfindung und beim Stand der Technik. Die gestrichelte Linie kennzeichnet die Ionenimplantation von Bor in eine polykristalline Siliciumschicht wie es in « Japanese Journal of Applied Physics », Vol. 15 (1976), Supplement 15-1, Seiten 49 bis 54 unter dem Titel « Application of Diffusion from Implanted Polycrystalline Silicon to Bipolar Transistors » beschrieben ist. In diesem Artikel wird Bor in eine polykristalline Siliciumschicht implantiert mit einer Dosis, die etwa der kritischen Dosis entspricht. Die Dosis für eine Schichtdicke von 150 nm beträgt dabei $1 \times 10^{15}$ Ionen/cm$^2$. Die Störstellenverteilung in der polykristallinen Siliciumschicht ist durch die gestrichelte Linie links von der die Grenzfläche definierenden vertikalen Linie dargestellt. Nach dem Eintreiben des Bors zur Erzeugung einer Basiszone erhält man die durch die gestrichelte Linie rechts von der die Grenzfläche definierenden vertikalen Linie aufgezeichnete Störstellenverteilung in der monokristallinen Siliciumschicht. Das erfindungsgemäße Verfahren, bei dem eine Dosis über der kritischen Dosis von $1 \times 10^{16}$ Ionen/cm$^2$ bei einer Implantationsenergie von 25 keV aufgewendet wird, erhält man die durch die ausgezogene Linie links von der Grenzfläche gekennzeichnete Störstellenverteilung. Nach dem Eintreibprozeß erhält man eine Emitterzone, deren Störstellenverteilung durch die ausgezogene Linie rechts von der Grenzfläche wiedergegeben ist.

Gemäß der Erfindung wird eine Dosis von etwa $1 \times 10^{16}$ bis etwa $1 \times 10^{17}$ Ionen/cm$^2$ aufgewendet, um die gewünschte Beladung der polykristallinen Siliciumschicht zu erhalten. Die erforderliche Implantationsenergie um diese Dosis zu implantieren und die gewünschte Störstellenverteilung in der polykristallinen Siliciumschicht zu erhalten, hängt von der Dicke der polykristallinen Siliciumschicht ab. Als optimale Implantationsenergie ergibt sich die, die durch die mittlere Kurve in Fig. 24 angedeutet ist. Andere Implantationsenergien können angewandt und die minimale und die maximale Energie, mit denen die Implantation durchgeführt werden kann, ergibt sich aus der unteren und der oberen Kurve der Darstellung gemäß Fig. 24. Als Beispiel sei angeführt, daß bei einer Schichtdicke der polykristallinen Siliciumschicht von 50 nm eine Implantationsenergie im Bereich von etwa 2 bis etwa 8 keV in Frage kommt. Einer Schichtdicke von 150 nm liegt die brauchbare Implantationsenergie im Bereich von etwa 15 bis etwa 27 keV. Schließlich erhält man eine Implantationsenergie im Bereich von etwa 25 bis etwa 43 keV für eine Schichtdicke von 250 nm.

**Ansprüche**

1. Verfahren zur Herstellung einer bipolaren, vertikalen PNP-Transistorstruktur, die mit Transistoren

# 0 032 550

des Komplementären Typs integrierbar ist, deren Kollektorzone (38) in einem Silizium-Halbleitersubstrat (10), deren Basiszone (78) in einer auf das Siliziumsubstrat (10) aufgebrachten Silizium-Epitaxieschicht (40) und deren Emitterzone (88) in der Basiszone (78) verwirklicht ist, wobei die Emitterzone (88) in die Basiszone (78) aus einer aufgebrachten, mittels Ionenimplantation dotierten polykristallinen Siliziumschicht (92) durch Festkörperdiffusion von Störstellen eingebracht wird, dadurch gekennzeichnet, daß bei der Implantation von Borionen in die polykristalline Siliziumschicht (92) die Implantationsenergie von der Dicke der polykristallinen Siliziumschicht (92) nach folgender Tabelle entsprechend den Kurven der Figur 24 abhängt

| Dicke der polykristallinen Siliziumschicht in Nanometern | Implantationsenergie der Borionen in KeV |
|---|---|
| 50 | 2 bis 8 |
| 150 | 15 bis 27 |
| 250 | 25 bis 43, |

wobei die Dosis etwa $1 \times 10^{16}$ bis etwa $1 \times 10^{17}$ Ionen/cm$^2$ beträgt, die sich anschließende Wärmebehandlung zur Bildung der Emitterzone (88) durch Eintreiben der Störstellen in die Basiszone (78) nach einem Zeit-Temperaturprogramm erfolgt, bei dem die Störstellenkonzentration in der Emitterzone (88) bis zu einer Tiefe von mindestens 200 nm mehr als $1 \times 10^{19}$ Atome/cm$^3$ und in einer Tiefe von 350 nm weniger als $1 \times 10^{16}$ Atome/cm$^3$ beträgt (Figuren 17 bis 22).

2. Verfahren nach Anspruch 1, dadurch gekennzeichnet, daß das Eintreiben der Emitterzone (23) durch eine Wärmebehandlung bei einer Temperatur von etwa 900 bis etwa 1 100 °C durchgeführt wird, wobei die Einwirkzeit der niedrigeren Temperatur etwa 90 Min. und die Einwirkzeit der höheren Temperatur etwa 2 Min. beträgt.

3. Verfahren nach Anspruch 1, dadurch gekennzeichnet, daß das Eintreiben der Emitterzone (23) durch eine Wärmebehandlung bei einer Temperatur von etwa 950 °C bis etwa 1 000 °C durchgeführt wird, wobei die Einwirkzeit der niedrigeren Temperatur etwa 60 Min. und die Einwirkzeit der höheren Temperatur etwa 45 Min. beträgt.

4. Verfahren nach Anspruch 1, dadurch gekennzeichnet, daß das Eintreiben der Emitterzone (23) durch eine Wärmebehandlung bei einer Temperatur von etwa 1 100 °C und einer Einwirkzeit von etwa 30 Min. erfolgt.

5. Verfahren nach den Ansprüchen 1 bis 4, dadurch gekennzeichnet, daß die Bedingungen beim Eintreiben der Emitterzone (23) so gewählt werden, daß die Eindringtiefe weniger als 250 nm beträgt.

6. Transistorstruktur, hergestellt nach dem Verfahren nach den Ansprüchen 1 bis 5, dadurch gekennzeichnet, daß sich in einem Sperrgebiet (18) des N-Leitungstyps, das in das Halbleitersubstrat (10) des P-Leitungstyps eingebracht ist, eine Subkollektorzone (38) des P-Leitungstyps befindet, wobei die Störstellenkonzentration im Sperrgebiet (38) am Übergang zur Subkollektorzone (18) in einem Bereich von etwa $1 \times 10^{16}$ bis etwa $5 \times 10^{17}$ Atome/cm$^3$ und die maximale Störstellenkonzentration in der Subkollektorzone (38) im Bereich von etwa $1 \times 10^{18}$ bis etwa $1 \times 10^{20}$ Atome/cm$^3$ liegt, daß in der auf der Oberfläche des Halbleitersubstrats (10) und damit der Subkollektorzone (38) und des Sperrgebiets (18) aufgebrachten Epitaxieschicht (40) über der Subkollektorzone (38) die Basiszone (78) des N-Leitungstyps gebildet ist, daß in die Basiszone (78) aus der aufgebrachten, P-dotierten polykristallinen Schicht durch Diffusion von Störstellen die Emitterzone (88) des P-Leitungstyps eingebracht ist und daß in der Basiszone (78) eine N-Basiskontaktzone (82) und in der Epitaxieschicht (40) außerhalb der Basiszone (78) eine P-Kollektorkontaktzone angeordnet ist.

7. Transistorstruktur nach Anspruch 6, dadurch gekennzeichnet, daß ein zu dieser Struktur komplementärer Transistor aus einer in das Halbleitersubstrat (10) außerhalb des Sperrgebietes (18) eingebrachten Subkollektorzone (22) des ersten Leitungstyps, einer in der auf das Halbleitersubstrat (10) aufgebrachten Epitaxieschicht (40) verwirklichten Basiszone (74) des zweiten Leitungstyps, ferner aus in die Basiszone eingebrachter Emitterzone (84) des ersten Leitungstyps und Basiskontaktzone des zweiten Leitungstyps und schließlich aus einer in die Epitaxieschicht (40) eingebrachten Kollektorkontaktzone (70, 72) des ersten Leitungstyps zusammengesetzt ist.

8. Verfahren zur Herstellung der Transistorstruktur nach Anspruch 7, dadurch gekennzeichnet, daß in das Halbleitersubstrat (10) ein Sperrgebiet (18) eingebracht wird, daß in das Sperrgebiet (18) die Subkollektorzone (38) des PNP-Transistors eingebracht wird, daß die Subkollektorzone (22) des komplementären Transistors in das Halbleitersubstrat (10) eingebracht wird, daß die Epitaxieschicht (40) auf das Halbleitersubstrat (10) aufgebracht wird und daß mit Hilfe von in einer auf die Epitaxieschicht aufgebrachte Maskierungsschicht gebildeten Maskenfenstern die Basiszonen, Emitterzonen und Basiskontaktzonen und die Kollektorkontaktzonen beider Transistoren eingebracht werden.

9. Verfahren nach Anspruch 8, dadurch gekennzeichnet, daß gleichzeitig mit der Subkollektorzone (38) des PNP-Transistors dessen Struktur und/oder die komplementäre Transistorstruktur umgebende, dotierte Isolationszonen (30, 32, 34) des zweiten Leitungstyps in das Halbleitersubstrat (10) eingebracht werden.

10. Verfahren nach Anspruch 9, dadurch gekennzeichnet, daß in die Oberfläche der Epitaxieschicht (40) über den dotierten Isolationszonen (30, 32, 34) abgesenkte Oxid-Isolationszonen (56, 60, 64) gebildet werden.

## Claims

1. Method of making a bipolar vertical PNP transistor structure which is integrated with transistors of the complementary type, whose collector region (38) is implemented in a silicon semiconductor substrate (10), whose base region (78) is implemented on a silicon epitaxial layer (40) deposited on the silicon substrate (10), and whose emitter region (88) is implemented in the base region (78), the emitter region (88) being diffused in the base region (78) out of a deposited polycristalline silicon layer (92) doped by means of ion implantation, through solid state diffusion of impurities, characterized in that during the implantation of boron ions into the polycristalline silicon layer (92) the implantation energy depends on the thickness of the polycristalline silicon layer (92) following the below given table in accordance with the curves of Fig. 24

| Thickness of the poly-cristalline silicon layer in nanometers | Implantation energy of the boron ions in KeV |
|---|---|
| 50 | 2 to 8 |
| 150 | 15 to 27 |
| 250 | 25 to 43 |

with the dosage being approximately $1 \times 10^{16}$ to approximately $1 \times 10^{17}$ ions/cm$^2$, the subsequent heat treatment to form the emitter region (88) by the diffusion of impurities into the base region (78) being implemented in accordance with a time-temperature program where the impurity concentration in the emitter region (88) is down to a depth of at least 200 nm more than $1 \times 10^{19}$ atoms/cm$^3$ and in a depth of 350 nm less than $1 \times 10^{16}$ atoms/cm$^3$ (Figs. 17 to 22).

2. Method as claimed in claim 1, characterized in that the emitter region (23) is driven in by a heat processing at a temperature of approximately 900 °C to approximately 1 100 °C, the respective period for the lower temperature amounting to approximately 90 minutes, and the period for the higher temperature to approximately 2 minutes.

3. Method as claimed in claim 1, characterized in that the emitter region (23) is driven in by a heat treatment at a temperature of approximately 950 °C to approximately 1 000 °C, the period of time for the lower temperature amounting to approximately 60 minutes, and the period for the higher temperature to approximately 45 minutes.

4. Method a claimed in claim 1, characterized in that the emitter region (23) is driven in by a heat treatment at a temperature of approximately 1 100 °C for a period of time amounting to approximately 30 minutes.

5. Method as claimed in any one of claims 1 to 4, characterized in that the conditions during the drivingin of the emitter region (23) are selected in such a manner that the penetration depth is less than 250 nm.

6. Transistor structure, made in accordance with the method as claimed in any one of claims 1 to 5, characterized in that in a barrier region (18) of the N-conductivity type which is provided in the semiconductor substrate (10) of the P-conductivity type there is a subcollector region (38) of the P-conductivity type, the impurity concentration in the barrier region (38) at the junction to the subcollector region (18) being in the range from about $1 \times 10^{16}$ to about $5 \times 10^{17}$ atoms/cm$^3$, and the maximum impurity concentration in the subcollector region (38) being in the range from approximately $1 \times 10^{18}$ to approximately $1 \times 10^{20}$ atoms/cm$^3$, that in the epitaxial layer (40) which is deposited on the surface of the semiconductor substrate (10) and thus of the subcollector region (38) and of the barrier region (18), and over the subcollector region (38) the base region (78) of the N-conductivity type is formed, that into the base region (78) the emitter region (88) of the P-conductivity type is diffused out of the deposited, P-doped polycristalline layer by the diffusion of impurities, and that in the base region (78) an N-base contact region (82), and in the epitaxial layer (40) outside the base region (78) a P-collector contact region is arranged.

7. Transistor structure as claimed in claim 6, characterized in that a transistor complementary to this structure is composed of a subcollector region (22) of the first conductivity type diffused into the semiconductor substrate (10) outside the barrier region, of a base region (74) of the second conductivity

**0 032 550**

type implemented in the epitaxial layer (40) deposited on the semiconductor substrate (10), furthermore of the emitter region (84) of the first conductivity type and the base contact region of the second conductivity type diffused into the base region, and finally of a collector contact region (70, 72) of the first conductivity type diffused into the epitaxial layer (40).

8. Method of making the transistor structure as claimed in claim 7, characterized in that into the semiconductor substrate (10) a barrier region (18) is diffused, that into the barrier region (18) the subcollector region (38) of the PNP transistor is diffused, that the subcollector region (22) of the complementary transistor is provided in the semiconductor substrate (10), that the epitaxial layer (40) is deposited on the semiconductor substrate (10), and that by means of mask windows made in a masking layer deposited on the epitaxial layer the base regions, emitter regions and base contact regions and the collector contact regions of both transistors are made.

9. Method as claimed in claim 8, characterized in that simultaneously with the subcollector region (38) of the PNP transistor isolation regions (30, 32, 34) of the second conductivity type which surround its structure and/or the complementary transistor structure are diffused in the semiconductor substrate (10).

10. Method as claimed in claim 9, characterized in that oxide isolation regions (56, 60, 64) lowered into the surface of the epitaxial layer (40) over the doped isolation regions (30, 32, 34) are formed.

**Revendications**

1. Procédé pour fabriquer une structure de transistor PNP bipolaire vertical, qui peut être intégrée avec des transistors du type complémentaire et dont la zone de collecteur (38) est réalisée dans un substrat semiconducteur en silicium (10), dont la zone de base (78) est réalisée dans une couche épitaxiale en silicium (40) déposée sur le substrat en silicium (10) et dont la zone d'émetteur (88) est réalisée dans la zone de base (78), la zone d'émetteur (88) située dans la zone de base (78) étant ménagée à partir d'une couche de silicium polycristallin (92) déposée et dopée au moyen d'une implantation d'ions, à l'aide d'une diffusion d'impuretés dans un corps solide, caractérisé en ce que lors de l'implantation d'ions de bore dans la couche de silicium polycristallin (92), l'énergie d'implantation dépend de l'épaisseur de cette couche conformément au tableau suivant, en correspondance avec les courbes de la figure 24

| Epaisseur de la couche de silicium polycristallin en nanomètres | Energie d'implantation des ions de bore en keV |
|---|---|
| 50 | 2 à 8 |
| 150 | 15 à 27 |
| 250 | 25 à 43, |

auquel cas la dose est comprise entre environ $1 \times 10^{16}$ et environ $1 \times 10^{17}$ ions/cm², le traitement thermique ultérieur pour la formation de la zone d'émetteur (88) est réalisé par insertion des impuretés dans la zone de base (78) conformément à un programme durée-température pour laquelle la concentration d'impuretés dans la zone d'émetteur (88) jusqu'à une profondeur d'au moins 200 nm est supérieure à environ $1 \times 10^{19}$ atomes/cm³ et selon lequel cette concentration à une profondeur de 350 nm est inférieure à $1 \times 10^{16}$ atomes/cm³ (figures 17 à 22).

2. Procédé selon la revendication 1, caractérisé en ce que l'insertion de la zone d'émetteur (23) est réalisée au moyen d'un traitement thermique à une température d'environ 900 à environ 1 100 °C, la durée d'action à la température inférieure étant égale à environ 90 mn et la durée d'action à la température supérieure étant égale à environ 2 mn.

3. Procédé selon la revendication 1, caractérisé en ce que l'insertion de la zone d'émetteur (23) est réalisée au moyen d'un traitement thermique à une température comprise entre environ 950 °C et environ 1 000 °C, la durée d'action à la température inférieure étant égale à environ 60 mn et la durée d'action à la température supérieure étant égale à environ 45 mn.

4. Procédé selon la revendication 1, caractérisé en ce que l'insertion de la zone d'émetteur (23) est réalisée au moyen d'un traitement thermique à une température d'environ 1 100 °C et avec une durée d'action d'environ 30 mn.

5. Procédé selon les revendications 1 à 4, caractérisé en ce que les conditions lors de l'insertion de la zone d'émetteur (23) sont choisies de telle sorte que la profondeur de pénétration est inférieure à 250 nm.

6. Structure à transistor, fabriquée selon le procédé conformément aux revendications 1 à 5, caractérisé en ce qu'une zone sous collecteur (38) possédant le type de conductivité P est située dans la région de blocage (18) possédant le type de conductivité N, qui est ménagée dans le substrat

10

semiconducteur (10) possédant le type de conductivité P, avec une concentration des impuretés dans la région de blocage (38) au niveau de la jonction avec la zone sous collecteur (18) comprise dans une gamme allant d'environ $1 \times 10^{16}$ jusqu'à environ $5 \times 10^{17}$ atomes/cm$^3$ et avec une concentration maximum des impuretés dans la zone sous collecteur (38) comprise dans la gamme allant d'environ $1 \times 10^{18}$ jusqu'à environ $1 \times 10^{20}$ atomes/cm$^3$, que la zone de base (78) possédant le type de conductivité N est formée au-dessus de la zone sous collecteur (38) dans la couche épitaxiale (40) déposée sur la surface du substrat semiconducteur (10) et par conséquent de la zone sous collecteur (38) et de la région de blocage (18), que la zone d'émetteur (88) possédant le type de conductivité P est insérée par diffusion d'impuretés dans la zone de base (78) à partir de la couche polycristalline déposée et dopée de type P, et qu'une zone de contact de base de type N (82) est disposée dans la zone de base (78) et qu'une zone de contact de collecteur de type P est disposée dans la couche épitaxiale (30) à l'extérieur de la zone de base (78).

7. Structure de transistor selon la revendication 6, caractérisée en ce qu'un transistor, complémentaire à cette structure est constitué par une zone sous collecteur (22) possédant le premier type de conductivité, insérée dans le substrat semiconducteur (10) à l'extérieur de la région de blocage (18), par une zone de base (74) possédant le second type de conductivité réalisée dans la couche épitaxiale (40) déposée sur le substrat semiconducteur (10) et en outre par une zone d'émetteur (84) possédant le premier type de conductivité et par une zone de contact de base possédant le second type de conductivité insérée dans la zone de base et enfin par une zone de contact de collecteur (70, 72) possédant le premier type de conductivité et insérée dans la couche épitaxiale (40).

8. Procédé pour fabriquer la structure de transistor selon la revendication 7, caractérisé en ce qu'une région de blocage (18) est insérée dans le substrat semiconducteur (10), que la zone sous collecteur (38) du transistor PNP est insérée dans la région de blocage (18), que la zone sous collecteur (22) du transistor complémentaire est insérée dans le substrat semiconducteur (10), que la couche épitaxiale (40) est déposée sur le substrat semiconducteur (10) et que les zones de base, les zones d'émetteur et les zones de contact de base et les zones de contact de collecteur des deux transistors sont ménagées à l'aide de fenêtres de masque formées dans une couche de masquage disposée sur la couche épitaxiale.

9. Procédé selon la revendication 8, caractérisé en ce qu'on aménage, en même temps que la zone sous collecteur (38) du transistor PNP, des zones isolantes dopées (30, 32, 34) entourant la structure de ce transistor et/ou la structure du transistor complémentaire, et possédant le second type de conductivité, dans le substrat semiconducteur (10).

10. Procédé selon la revendication 9, caractérisé en ce que l'on forme des zones isolantes d'oxyde (56, 60, 64) en renfoncement au-dessus des zones isolantes dopées (30, 32, 34) dans la surface de la couche épitaxiale (40).

FIG. 1

FIG. 2

FIG. 3

FIG. 4

FIG. 5

FIG. 6

FIG. 7

2

**0 032 550**

FIG. 8

IMPL.POLYKRIST. SILICIUM

KONZ.CO (ATOME / cm³)

$10^{20}$
$10^{19}$
$10^{18}$
$10^{17}$
$10^{16}$

P

N

P

N

P-SUBSTRAT

0,25    1    2    3    4    5    6

TIEFE ($\mu$m)

FIG. 9

KONZ. CO (ATOME/ cm³)

$10^{20}$
$10^{19}$
$10^{18}$
$10^{17}$
$10^{16}$

N    P

P

N

P-SUBSTRAT

1    2    3    4    5    6

TIEFE ($\mu$m)

FIG. 10

FIG. 11

FIG. 12

FIG. 13

FIG. 14

FIG. 15

FIG. 16

FIG. 17

KONZ. (IONEN/cm$^3$)

5 keV  1 x 10$^{16}$ IONEN/cm$^2$

ABSTAND VON GRENZFLÄCHE (nm)

FIG. 18

KONZ. (IONEN/cm$^3$)

1000°C — 30 MIN.

ABSTAND VON GRENZFLÄCHE (nm)

FIG. 19

KONZ.
(IONEN/cm$^3$)

~ 25 keV

ABSTAND VON GRENZFLÄCHE (nm)

FIG. 20

KONZ.
(IONEN/cm$^3$)

1000°C - 30 MIN.

ABSTAND VON GRENZFLÄCHE (nm)

7

40 keV    1 x $10^{16}$ IONEN/$cm^2$

KONZ.
(IONEN/$cm^3$)

250    100    0    100    200    300    400

**FIG. 21**

← →
ABSTAND VON GRENZFLÄCHE (nm)

1000°C – 30 MIN.

KONZ.
(IONEN/$cm^3$)

250    100    0    100    200    300    400

**FIG. 22**

← →
ABSTAND VON GRENZFLÄCHE (nm)

FIG. 23

FIG. 24